(19) Europäisches Patentamt
European Patent Office
Office européen des brevets

(11) **EP 4 390 414 A1**

(12) **EUROPEAN PATENT APPLICATION**

(43) Date of publication:
**26.06.2024 Bulletin 2024/26**

(21) Application number: **22216009.5**

(22) Date of filing: **22.12.2022**

(51) International Patent Classification (IPC):
**G01R 31/34** (2020.01)          **G01R 31/52** (2020.01)

(52) Cooperative Patent Classification (CPC):
**G01R 31/346; G01R 31/52;** G01R 31/343

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Siemens Gamesa Renewable Energy A/S**
**7330 Brande (DK)**

(72) Inventor: **Freire, Nuno Miguel Amaral**
**7330 Brande (DK)**

(74) Representative: **SGRE-Association**
**Siemens Energy Global GmbH & Co. KG**
**SE I IM P Intellectual Property**
**Siemenspromenade 9**
**91058 Erlangen (DE)**

(54) **COMPUTER-IMPLEMENTED METHOD FOR MONITORING A GENERATOR OF A WIND TURBINE, WIND TURBINE, COMPUTER PROGRAM AND ELECTRONICALLY READABLE STORAGE MEDIUM**

(57)    Computer-implemented method for monitoring a generator (13) of a wind turbine (1) for detecting interturn short-circuit faults in at least one stator winding set (15, 23) of the generator (13), wherein a strength of a second harmonic of a power produced from the stator winding set (15, 23) and the DC value of the power are determined,

wherein, in respective time steps,

- a first analysis criterion describing the DC value of the power being constant evaluates the DC value of the power,

- a second analysis criterion describing the occurrence of a transient in the strength of the second harmonic evaluates the strength of the second harmonic, and

- an interturn short-circuit fault signal is generated if the first and the second analysis criterion both yield true for a given number of time steps.

FIG 4

## Description

The invention concerns a computer-implemented method for monitoring a generator of a wind turbine for determining interturn short-circuit faults in at least one stator winding set of the generator, wherein a strength of a second harmonic of a power produced from the stator winding set and the DC value of the power are determined. The invention further concerns a wind turbine, a computer program and an electronically readable storage medium.

Wind turbines, as known in the state of the art, usually use a generator to convert mechanical energy, in particular wind energy, from a blade assembly of the wind turbine to electrical energy, in particular power to drive electrical devices and/or to be fed into an electric grid. The generator usually comprises a rotor rotated by wind power impinging onto wind turbine blades of the wind turbine and a stator having stator windings, into which electric currents are induced due to the rotation of the rotor. In addition to the electrical machine forming the generator, a generator arrangement of a wind turbine usually comprises at least one channel, wherein each channel comprises a breaker, a converter unit and a set of stator windings of the generator connected to the converter unit via the breaker.

In particular, multi-stator electrical machines have been proposed, whose stator comprises two or more sets of stator windings. Using multiple sets of stator windings allows to, for example, continue operation of the wind turbine even if one set of the stator windings or the corresponding generator is faulty.

Generally speaking, a wide variety of fault conditions may occur regarding a generator arrangement of a wind turbine. Such faults may result in serious damage to the wind turbine, in particular even destroying components of the generator arrangement, for example by fires flaring up due to the fault. To detect such faults as early as possible to react with certain protection measures, it has been proposed to monitor the operation of the wind turbine, in particular of the generator arrangement, for example by providing a monitoring device in the wind turbine. However, known monitoring methods may not be able to detect all kinds of fault conditions in time before damage occurs.

In WO 2019/037 908 A1, a method and an arrangement for monitoring a first winding set and at least one second winding set of a stator of a generator during operation has been proposed. Here, in particular, high-resistance connections are addressed, which may result from loose connections (due to poor workmanship, thermal cycling and corrosion or contamination). Such high-resistance connections may evolve to open-circuit faults. Furthermore, secondary damage may be expected as a consequence of overheating and excessive vibrations. To detect such faults, a fault diagnostic method which is configured for online condition monitoring and protection of generators employed in wind turbines is proposed, wherein high-resistance connections in multi-stator permanent magnet generators are detected, enabling the converter controller to stop operation or apply other measures, for example shutting down the faulty winding set. Here, a first strength of a second harmonic of a power produced from the first winding set and a second strength of a second harmonic of a second power produced from the second winding set are obtained and the first winding set and/or the second winding set are diagnosed based on a second harmonic power difference between the first strength and the second strength. The first power as well as the second power may comprise active power and/or reactive power.

The second harmonic is an oscillation, for example of the output voltage and/or the output current of the respective stator winding set, which oscillates with two times the fundamental electrical frequency of the generator. In the ideal case, where no deterioration or fault is present, any of the winding sets is expected to only deliver a power stream of the fundamental electrical frequency such that the strength of the second harmonic is essentially zero. In the case that the second harmonic of the respective power is not zero or not smaller than a threshold, it may already indicate that the respective winding set is at least partially faulty. It has been found that, if there is a deviation between the first strength and the second strength, it may indicate that one of the stator winding sets, in particular the one which has the higher strength of the second harmonic, is at least partly faulty, in particular exhibiting high-resistance connections.

WO 2020/128 058 A1 discloses a method for determination of a location of a short-circuit fault in a generator arrangement. Here, a short-circuit fault is detected by the large current exceeding the current during proper operation of the generator arrangement. To detect if the short-circuit fault occurred in the generator or the converter unit, a measurement describing a torque ripple of the electrical machine is performed after opening the breaker. However, if large currents leading to opening of breakers are detected, there may have already been damage to the generator arrangement or elsewhere in the wind turbine.

Such large short-circuit currents may be the result of less obvious fault conditions, for example interturn short-circuit faults. Here, physical quantities wherein interturn short-circuit faults are detectable may be known, however, these effects are often very small, such that sufficiently low detection thresholds may lead to a large number of false alarms, which is disadvantageous. In particular, in known approaches, lowering the threshold to required levels is not possible due to production tolerances (manufacturing differences between generators of the same type) and dependances on the operating conditions, for example stator and rotor temperatures, generator speed and currents. Accordingly, interturn short-circuit faults are often detected too late and cause extensive damage. Experience has shown that wind turbines are often stopped minutes or even hours after the interturn short-circuit fault occurrence by smoke or temperature alarms.

It is an object of the current invention to provide a monitoring method allowing early, in particular reliable and/or robust, detection of interturn short-circuit faults.

This object is achieved by providing a computer-implemented method, a wind turbine, a computer program and an electronically readable storage medium according to the independent claims. Advantageous embodiments are described by the dependent claims.

In a method as initially described, according to the invention, in respective time steps,

- a first analysis criterion describing the DC value of the power being constant evaluates the DC value of the power,
- a second analysis criterion describing the occurrence of a transient in the strength of the second harmonic evaluates the strength of the second harmonic, and
- an interturn short-circuit fault signal is generated if the first and the second analysis criterion both yield true for a given number of time steps.

Here, the given number of time steps may be one, however, to increase robustness and reliability, the given number may be at least two. Generally, in each time step, measurement results for the power and thus its DC value and the strength of the second harmonic are obtained and the criteria are correspondingly evaluated. By requiring both results to be true for more than one time step to detect an interturn short-circuit fault, a sort of "fault maturing" is achieved, improving robustness and reliability by, in particular, decreasing the number of false alarms. Here, the analysis may refer to successive time steps, and the given number may correspond to a time interval or time threshold. For example, the given number may be choses to correspond to a time interval of 2 to 10 seconds, which has proven advantageous regarding filtering measures applied in embodiments, as further discussed below.

Generally speaking, in particular by analyzing field data of wind turbines, it has been found that interturn short-circuit faults are detectable from transients in the strength, in particular amplitude, of the second harmonic of the power, in particular regarding the difference of the relative strength of the second harmonic and an expected value for said relative strength. However, it has also been found that the amplitude variations in these strength-related signals are usually very low, in particular significantly lower than employed fault detection thresholds. It has also been observed that fault detection is difficult under varying operating conditions, for example varying power, due to a low signal-to-noise ratio. Accordingly, in this disclosure, it is proposed to detect transients in the strength of the second harmonic only in time windows where the power, described by its DC value, is approximately constant. Hence, two analysis criteria are employed, namely a first analysis criterion producing a first result signal, wherein the first result signal indicates true if the DC value is at least essentially, that is approximately, constant, according to the first analysis criterion, which, in other words, describes the degree of constancy (or steadiness, since the requirement is to be in steady-state operation) required. On the other hand, the second analysis criterion produces a second result signal, which indicates true, that is fulfillment of the second analysis criterion, if a transient in the strength, in particular amplitude, of the second harmonic is detected. Only if both result signals indicate true, that is fulfillment of the respective analysis criteria, the presence of a fault may be detected.

In other words, the invention is based on the insight that, apart from interturn short-circuit faults, the second analysis criterion is usually, that is if no interturn short circuit fault is present, only fulfilled if there is relevant variation in the power, in particular its DC value. Hence, as an additional condition to detect an interturn short-circuit fault, steadiness (constancy) of the DC value of the power is required, such that the number of false alarms can be significantly reduced or false alarms can even be completely prevented.

In summary, the present invention provides a solution for online interturn short-circuit fault detection and protection of generators employed in wind turbines. Turn-turn short-circuit faults can be reliably and robustly detected in such permanent magnet generators while the number of false alarms can be held to a sufficiently low level.

Here, it is noted that the strength of the second harmonic may be determined as, for example, disclosed in already-mentioned WO 2019/037 908 A1. In particular, the second harmonic is an oscillation, for example of the output voltage and/or output current of the stator winding set, which oscillates with two times a fundamental electrical frequency of the generator. The fundamental electrical frequency is proportional to a rotational speed of a rotor rotating relative to the stator. In particular, the fundamental electrical frequency may be calculated as a product of the rotational speed of the rotor and the number of pole pairs of permanent magnets. Under normal operating conditions, the second harmonic (of a voltage, current and/or power) should be essentially zero.

In principle, embodiments of the present invention allow to exclusively consider the active power or exclusively consider the reactive power or consider a combination of reactive power and active power for diagnosis. However, in preferred embodiments, the power is an active power produced from the at least one stator winding set. In particular, if the deviation from an expected strength of the second harmonic, as further discussed below, is analyzed, it has been shown that choosing the active power as the power, in particular using the amplitude of the DC component as DC value and the amplitude of the second harmonic as the strength of the second harmonic, the values of the deviation are drastically reduced across the generator operating range.

As a general note, in a generator having a stator with multiple stator winding sets, of course, the method described here can be applied to each stator winding set, such that interturn short-circuit faults can be detected specifically for each of the stator winding sets.

In concrete embodiments, the DC value of the power may be determined by low pass filtering a measurement signal of the power and/or the strength of the second harmonic may be determined by band pass filtering the measurement signal with a bandpass filter centered around the second harmonic frequency. As already noted, the second harmonic frequency is two times the fundamental electrical frequency, which may be determined from the rotational speed of the rotor and the number of pole pairs of permanent magnets of the rotor. The measured signal may, for example, be obtained by measuring currents in the stator winding set using at least one current sensor. To determine the second harmonic, an adaptive bandpass filter is used, whereto the second harmonic frequency or directly the fundamental electrical frequency is provided. The strength of the second harmonic can then be determined as the amplitude of the bandpass-filtered measured signal. It is noted that time-averaging may also be applied, as described in WO 2019/037 908 A1.

In a preferred embodiment, a false result of the first evaluation criterion may be held for a predetermined number of time steps. In particular, if another false result is determined during these time steps, the holding time interval may be reset. In other words, if the DC value is determined as not being stable by the first analysis criterion, the result is held as false for a predetermined number of time steps to increase the robustness, in particular regarding short-term constancy at a high value and the like.

In a concrete, preferred embodiment, the first analysis criterion may compare the high-pass filtered absolute of the DC value with a first threshold value, wherein the power is assumed as constant as long as the high-pass filtered absolute of the DC value is lower than the first threshold value. By applying a high-pass filter, if the DC value is approximately constant, the high-pass filtered DC value assumes a value approximately equal to zero. The high-pass filtered DC value is then compared against a first threshold value indicating that the DC value and hence the power is stable, that is, approximately constant. The first threshold value may be understood as defining boundaries regarding the constancy of the DC value and can be generally applied, that is, under all operating conditions of the generator, since, due to the high-pass filtering, a deviation from zero is checked.

Regarding the transient detection, in advantageous embodiments, the second analysis criterion may compare an, in particular high-pass filtered, deviation value derived from the strength of the second harmonic to a second threshold value, wherein the deviation value is determined by

- determining a relative strength of the second harmonic by dividing the absolute of the strength, in particular the amplitude, of the second harmonic by the absolute of the DC value of the power,
- determining an expected value for the relative strength, and
- determining the deviation value as the absolute of the difference of the relative strength and the expected value, wherein the second analysis criterion indicates a transient if the deviation value exceeds the second threshold value.

It is hence proposed to analyze the deviation from an expectation, providing the advantage that the deviation value, again, can in some cases be at least approximately zero under normal operating conditions (healthy operation). It is, however, preferred to apply a high-pass filter to the deviation value signal, since, for example due to tolerances and the like, the expected value may be offset from the actually measured relative strength. The expected value (reference value) may be constant or, preferably, load dependent, wherein the load may be described by the DC value of the power. Such an expected value and/or a correlation of load and expected values may preferably be determined empirically and/or analytically, for example by statistically evaluating DC value and strength of the second harmonic measurements during normal, healthy operation, in particular in time windows where the first analysis criterion is fulfilled. A correlation may, for example, be provided as a look-up table relating the current load to expected values.

In concrete embodiments, the relative strength of the second harmonic may be determined as described in WO 2019/037 908 A1 for the determination of the diagnostic signal for each channel/stator winding set, for example as

$$d = \frac{X_{2f}}{|X_{DC}|} \qquad , \qquad (1)$$

wherein X stands for active power (preferred) or reactive power of the stator winding set, in particular $X_{DC}$ for the DC value (amplitude of the DC component) and $X_{2f}$ for the strength of the second harmonic, in particular the amplitude of the second harmonic. d is the relative strength. If, now, the expected value d* is provided, the deviation value describing a deviation between expected and currently measured values can be obtained by

$$g = |d - d*| \qquad (2)$$

Experiments and statistical data evaluation from the field have, as already noted, shown that the deviation value changes abruptly at the occurrence of an interturn short-circuit fault. In this regard, the deviation value or generally the strength of the second harmonic differ clearly from other signals usually measured, for example sound pressure level in the rotor hub or generator temperatures, which usually remain unchanged on occurrence of an interturn short-circuit fault.

Since a transient in the deviation value, indicating a transient in the strength of the second harmonic, is to be determined, the deviation value may also be high-pass filtered before comparison against the second threshold value. Here, it is noted that, since the additional condition of the first analysis criterion is checked, the second threshold value can be chosen very low, yielding a high sensitivity. However, due to the additional requirement of the first analysis criterion being fulfilled, false alarms are avoided.

It is noted that, in principle, it might be conceivable to compare strengths of the second harmonics between a pair of stator winding sets, requiring both DC values to be at least essentially constant. However, such a deviation value would be influenced by both variations and an additional criterion for power constancy would be required, resulting in such an embodiment to be less preferred.

Regarding both the first and the second threshold values, these may be determined empirically, in particular by evaluating data from healthily operated wind turbines and wind turbines in which an interturn short-circuit fault was detected, choosing both threshold values such that the number of false detections is minimized while a maximum of interturn short-circuit faults is correctly detected. Such analysis and experiments have been performed and have shown applicability and advantages of the method of the invention. In other words, validation has been successful.

In this context, in embodiments, the deviation value and/or the DC value may be pre-filtered before high pass filtering. For example, a suitable low pass filter can be applied. Here, pre-filtering of the DC value may, in embodiments, not be necessary, in particular if it has already been low pass filtered. Regarding the deviation value, however, pre-filtering may be advantageous to shape the resulting deviation value signal to allow best detection performance. In particular, by applying a low pass filter and a high pass filter, a band pass filter may be created and parametrized for optimal signal shaping.

If an interturn short-circuit fault is detected, corresponding measures to protect the generator and, hence, the wind turbine/the whole generator arrangement, can be executed. For example, if the interturn short-circuit fault signal indicates a detected interturn short-circuit fault, the generator, in particular at least the respective stator winding set, is shut down and/or a warning is output. For example, an afflicted stator winding set and the corresponding channel can be deactivated by opening a breaker in the respective channel. Warnings can be output at the wind turbine and/or, preferably, at a remote monitoring center.

It is noted that, in preferred embodiments, the short-circuit fault detection enabled by the method according to the invention can be combined with the monitoring/fault detection processes described in WO 2019/037 908 A1, since the strength of the second harmonic is also determined and used, in particular in embodiments also the relative strength mentioned. For example, the strength of the second harmonic may be further evaluated regarding at least one further fault condition, in particular by diagnosing two different stator winding sets based on a second harmonic power difference between the respective strength of the second harmonic. In this manner, in particular, additionally high-resistance connections can be detected.

The invention further concerns a wind turbine, comprising a generator having at least one stator comprising at least one stator winding set, measurement means for measuring a measurement signal of a power of the at least one stator winding set and a monitoring device, the monitoring device being configured to perform the steps of a method according to the invention. All features and remarks regarding the method according to the invention may be accordingly applied to the wind turbine according to the invention, such that the same advantages can be achieved. In an example, the measurement means may comprise current sensors for the windings.

The monitoring device may, in preferred embodiments, be provided as part of a control device of the wind turbine, for example of a controller of a frequency converter, a controller of the wind turbine or in a dedicated wind turbine conditions monitoring and protection system. The monitoring device may comprise at least one processor and/or at least one storage means. Functional units may be implemented in hardware and/or software to perform steps of a method according to the invention. For example, the monitoring device may comprise a pre-processing unit for determining the strength and the DC value from the measured signal, an optional determining unit for determining the deviation value, an analysis unit for evaluating the analysis criteria and detecting interturn short-circuit faults from the results, and/or an optional control unit for executing measures, for example opening breakers and/or outputting warnings.

A computer program according to the invention comprises program means configured to perform the steps of a method according to the invention if the computer program is executed on a monitoring device of a wind turbine. The computer program may be stored on an electronically readable storage medium according to the invention, which hence comprises control information stored thereon, which comprises at least a computer program according to the invention, such that, when the electronically readable storage medium is used in a monitoring device of a wind turbine, the monitoring device is configured to perform the steps of a method according to the invention.

Other objects and features of the present invention will become apparent from the following detailed description considered in conjunction with the accompanying drawings. The drawings, however, are only principle sketches designed solely for the purpose of illustration and do not limit the invention. The drawings show:

Fig. 1    schematically a wind turbine according to an embodiment of the invention,

Fig. 2    a graph explaining the monitoring process of the invention,

Fig. 3    a first functional diagram explaining an embodiment of a method according to the invention,

Fig. 4    a second functional diagram explaining an embodiment of a method according to the invention, and

Fig. 5    a full view of the wind turbine of Fig. 1.

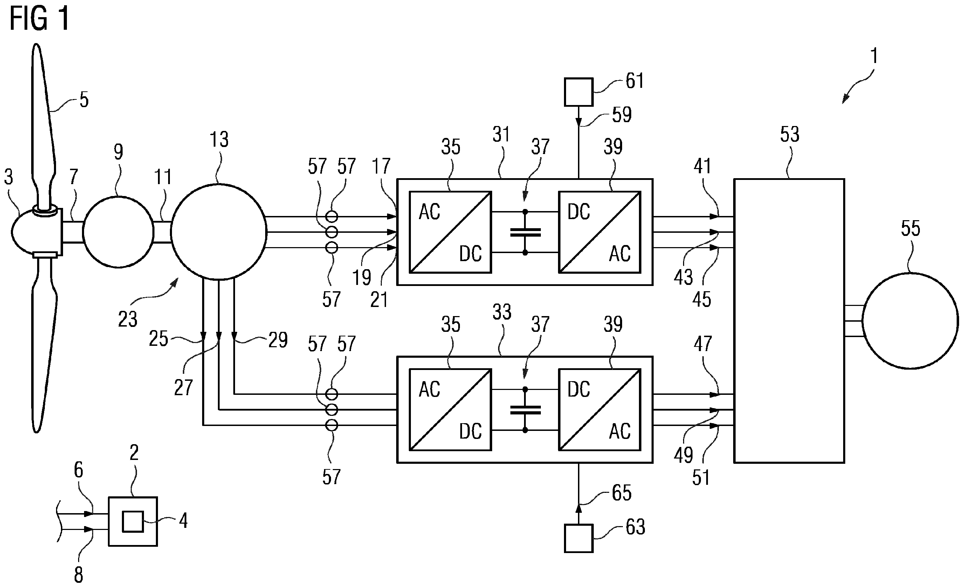

Fig 1 schematically illustrates relevant components a wind turbine 1 according to an embodiment of the invention. The wind turbine 1 comprises a rotor hub 3 to which multiple, for example three, wind turbine blades 5 are connected. The rotor hub 3 is connected to a rotation shaft 7 which is coupled to an optional gearbox 9. A secondary shaft 11 coupled to another end of the gearbox 9 is coupled to a generator 13. The stator of the generator 13 comprises, in this case, two stator winding sets 15, 23. At a first stator winding set 15, in particular three winding set, the generator 13 outputs first power as three phase currents 17, 19, 21. A second winding set 23 outputs second power as three phase currents 25, 27, 29. The first power produced by the first stator winding set 15 is supplied to a first AC-DC-AC converter 31 of a first channel and the second power is supplied to a second AC-DC-AC converter 33 of a second channel. Both converters 31, 33 comprise an AC-DC converter portion 35, a DC link 37 and a DC-AC converter portion 39. The converters 31, 33 are configured for converting a variable frequency AC power stream (currents 17, 19, 21 or 25, 27, 29) to a fixed frequency power stream, in particular three-phase power streams 41, 43, 45 or 47, 49, 51, respectively. The two power streams from the first stator winding set 15 and the second stator winding set 23 are transformed in a common transformer 53 to higher voltage to be provided as a three-phase power stream to an electrical grid 55.

The wind turbine 1 further comprises a monitoring device 2 for monitoring the first winding set 15 and the second winding set 23 of the generator 13 during operation regarding interturn short-circuit faults. The monitoring device 2 is configured to perform a method of monitoring the generator 13 according to the invention. Here, the monitoring device 2 comprises a processor 4 and a storage means and may be implemented as a stand-alone device or be integrated into another controller, for example a controller for the converters 31, 33, or generally for the wind turbine 1.

The monitoring device may comprise a pre-processing unit, which is configured to determine a first strength of a second harmonic of the first power produced from the first stator winding set 15, wherein the first power is supplied to the monitoring device 2 using a first measurement signal 6 which may be obtained by measuring currents in the first winding set 15 using current sensors 57. A second strength of a second harmonic of a second power produced from the second winding set 23 is correspondingly determined from a second measurement signal 8 indicative of the second power output by the second winding set 23. It is noted that in the wind turbine 1, concerning the permanent magnet synchronous generator 13, measured phase current and reference voltage are readily available and are used in embodiments of the present invention for monitoring purposes. Herein, the currents 17, 19, 21 output by the first stator winding set 15 measured using the current sensors 57 and the first reference voltage 59 as supplied by a controller 61 to the first converter 31 are used to derive the first power, supplied as first measurement signal 6 to the monitoring device 2. In an analogous manner, currents 25, 27, 29 and the reference voltage 65 (supplied by controller 63) of the second power stream as produced by the second winding set 23 are obtained and the respective second power is supplied as a second measurement signal 8 to the monitoring device 2.

In embodiments, the first and the second strengths may be used to diagnose the first winding set 15 and/or the second winding set 23 regarding high resistance connections based on a second harmonic power difference between the first strength and the second strength, as described in WO 2019/037908 A1. However, in the current invention, it has been found that the strength of the second harmonic for each of the stator winding sets 15, 23 also indicates interturn short-circuit faults by abrupt transients.

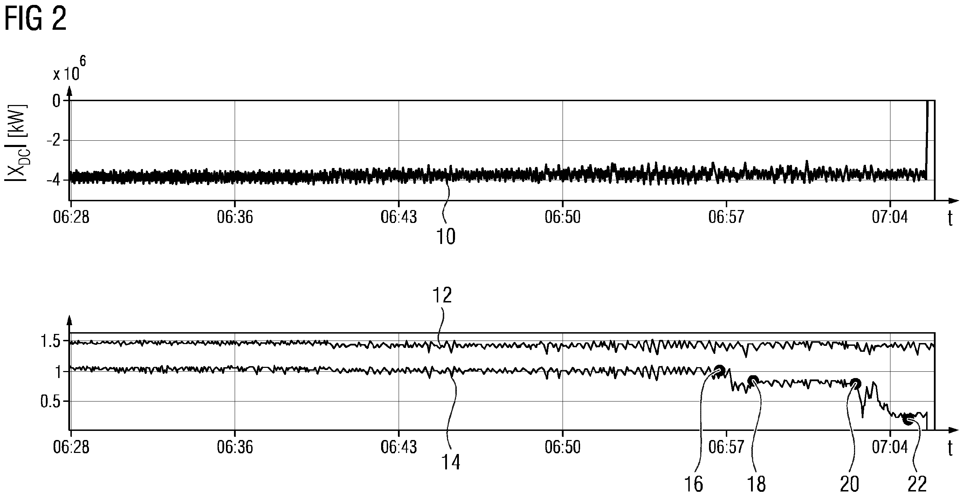

Fig. 2 shows, in an upper diagram, a graph 10 of the power output (measurement signal 6, 8) by a stator winding set 15, 23 as measured in a generator 13, while the lower diagram shows a graph 12 of an expected value of the relative strength of the second harmonic and a graph 14 of the measured relative strength (according to equation (1)) of the second harmonic. Between time points 16 and 18 as well as 20 and 22, clearly discernible transients occur in the graph 14, while the graph 12 remains at the same level. These transients are not caused by a variation the DC value, see graph 10, which remains at least essentially constant. The monitoring device 2 is hence also configured to detect interturn short-circuit faults if a transient occurs in the strength of the second harmonic of the power during at least approximately constant (stable) power.

In the following, active power is analyzed, however, the method may also be applied for reactive power and/or a combination. Further, monitoring regarding interturn short-circuit faults is performed for both stator winding sets 15, 23, that is each channel, independently and, in the following, illustrated for one of them.

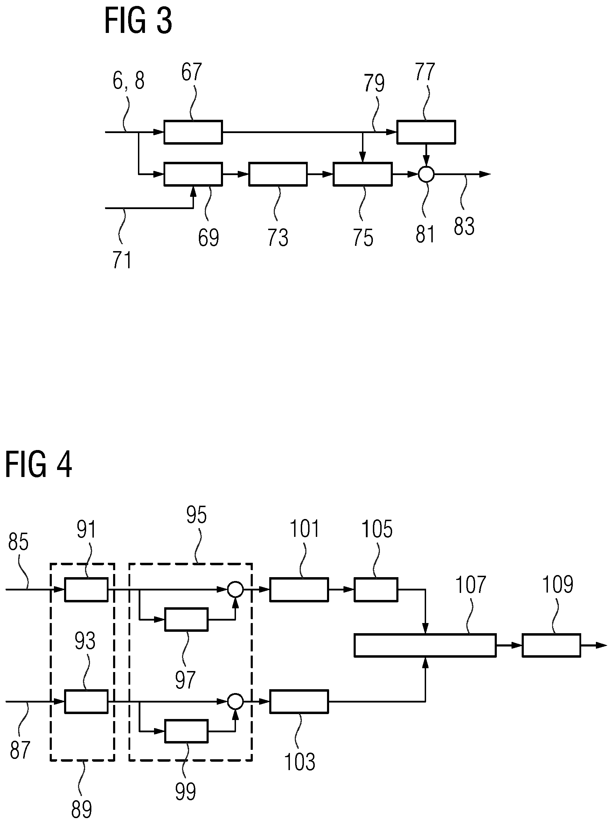

Fig. 3 illustrates how the pre-processing unit of the monitoring device 2 determines the DC value of the power and the strength, in this case the amplitude, of the second harmonic of the power from measurement signals 6, 8 for the respective of the first and second channel. To determine the DC value of the power, in this case the active power, a low pass filter 67 is applied to the measurement signal 6, 8. To determine the strength, a bandpass filter 69 is applied to the measurement signal 6, 8, which is centered around the second harmonic frequency, that is, two times the fundamental electrical frequency of the generator 13. The fundamental electrical frequency can be calculated as a product of the rotational speed of the rotor of the generator 13 and the number of pole pairs of permanent magnets of the generator 13, as discussed above. Here, the rotor speed 71 is provided as rotations per minute. From the filtering result, in a step 73, the amplitude of the second harmonic can be calculated as the strength of the second harmonic. To determine the relative strength of the second harmonic, as discussed in equation (1), both the DC value and the amplitude of the second harmonic are supplied to step 75.

In the current embodiment, transients in the strength of the second harmonic are detected using the deviation value defined in equation (2) above. Hence, in a step 77, an expected value for the relative strength d, that is d* in equations (2) is determined. The expected value may be constant or, as indicated by arrow 79, may be load-dependent, in this case dependent on the DC value determined by applying filter 67. In a step 81, the absolute of the difference of the relative strength determined in step 75 and the expected value determined in step 77 are calculated and output as the deviation value according to arrow 83. While the filters 67 and 69 and step 73 are applied in the pre-processing unit, steps 75, 77 and 81 may be performed in a determining unit of the monitoring device 2.

The determined DC value and the determined deviation value are then provided to an analysis unit of the monitoring device 2, wherein the processing steps of the analysis unit are illustrated in fig. 4. As illustrated by arrows 85 and 87, the DC value of the power and the deviation value are supplied to the analysis unit, respectively. Box 89 indicates optional pre-filtering steps, in particular by applying low pass filters 91 and/or 93. While the low pass filter 91 may be omitted if the desired signal shape is already achieved by low pass filter 67, low pass filter 93 may improve interturn short-circuit fault detection by providing additional signal shaping for the deviation value.

Box 95 indicates high pass filtering, as indicated by application of low pass filters 97, 99 and subsequent subtraction. For the DC value, high pass filtering allows to reduce the signal to actual changes, allowing to analyze for stable power by considering deviations from zero, which should be the high pass filtered DC value if the power is constant. Accordingly, since, is also shown in fig. 2, the expected value d* and the relative strength d do not necessarily have to match, by high pass filtering the deviation value signal can also be reduced to at least essentially zero as long as no transients, which are to be detected, occur. In particular, the combination of low pass filter 93 and high pass filtering provides a band pass filter which can empirically be parameterized to improve detection performance.

In steps 101 and 103, a first analysis criterion for the high pass filtered DC value and a second analysis criterion for the filtered deviation value are evaluated, respectively. The first analysis criterion of step 101 is for detection of stable power, that is, if the power is at least generally constant. Here, the high pass filtered DC value is compared to a first threshold value. As long as the high pass filtered DC value is lower than the first threshold value, power is assumed as being at least essentially constant. Hence, the first analysis criterion is fulfilled and "true" is output.

In an optional step 105, to increase robustness, a "false" output, that is, the first analysis criterion being not fulfilled, may be held for a predetermined number of time steps, for example time steps corresponding to a time interval of a few seconds. If, in this holding time interval, an additional "false" result of the first analysis criterion occurs, the time interval is correspondingly prolonged.

In the second analysis criterion, the high pass filtered deviation value is compared to a second threshold value. If the high pass filtered deviation value exceeds the second threshold value, the second analysis criterion is fulfilled and "true" is output, meaning that a transient has been detected.

The first and the second threshold may be determined empirically and/or analytically for example by evaluation field data from wind turbines correspondingly.

In a step 107, a fault detection logic is applied. Only if both analysis criteria yielded true results, that is, only if the power is stable and a transient has been detected in the strength of the second harmonic, an interturn short-circuit fault is detected. In this case, step 107 outputs "true". In step 109, fault maturing is performed. Here, an interturn short-circuit fault signal is only generated if the first and the second analysis criterion both yield true for a given number of successive time steps. For example, the given number of successive time steps may be chosen such that a transient has to be detected for a detection time interval of 2 to 10 seconds.

It is noted that the monitoring device 2 may, of course, also comprise a control unit for executing measures to protect the generator 13 and the wind turbine 1 in general when an interturn short-circuit fault has been detected. For example, if the interturn short-circuit fault signal indicates a detected interturn short-circuit fault, in particular by being "true", the generator 13, at least the channel having the respective stator winding set 15, 23, may be shut down. Preferably additionally, a warning may be output.

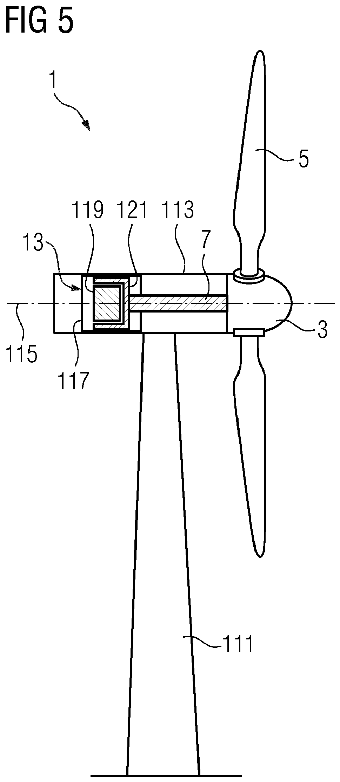

Fig. 5 shows a full view of the wind turbine 1. The wind turbine 1 comprises a tower 111, on which a nacelle 113 is arranged. The rotor hub 3 with its blades 5 is mounted to the nacelle 113. The hub 3 can be rotated about axial direction 115, wherein the respective rotation is driven by wind which interacts with the blades 5. As already explained with respect to Fig. 1, the rotation of the rotor hub 3 is transferred to the generator 13 via the rotation shaft 7 (and optionally the gearbox 9 and the secondary shaft 11, which are not shown for simplicity in Fig. 5). The axial direction 115 is arranged horizontally, but can also be tilted with respect to the horizontal direction. While the total height of the wind turbine 1 is in the order of tens or hundreds of meters, the output power of the wind turbine 1 is in the range of multi-Megawatts, in particular between 1 and 40 Megawatts.

The electric generator 13 comprises a housing 117, the stator 119 and the rotor 121, wherein the stator 119 and the rotor 121 are arranged within the housing 117. The stator 119 is non-rotating. The rotor 121 is coupled to the rotor hub 3 as described above and can also rotate about the axial direction 115.

Although the present invention has been described in detail with reference to the preferred embodiment, the present invention is not limited by the disclosed examples from which the skilled person is able to derive other variations without departing from the scope of the invention.

**Claims**

1. Computer-implemented method for monitoring a generator (13) of a wind turbine (1) for detecting interturn short-circuit faults in at least one stator winding set (15, 23) of the generator (13), wherein a strength of a second harmonic of a power produced from the stator winding set (15, 23) and the DC value of the power are determined, **characterized in that**, in respective time steps,

   - a first analysis criterion describing the DC value of the power being constant evaluates the DC value of the power,
   - a second analysis criterion describing the occurrence of a transient in the strength of the second harmonic evaluates the strength of the second harmonic, and
   - an interturn short-circuit fault signal is generated if the first and the second analysis criterion both yield true for a given number of time steps.

2. Method according to claim 1, **characterized in that** the power is an active power produced from the at least one stator winding set (15, 23).

3. Method according to claim 1 or 2, **characterized in that** the DC value of the power is determined by low pass filtering a measurement signal (6, 8) of the power and/or the strength of the second harmonic is determined by band pass filtering the measurement signal with a band pass filter (69) centered around the second harmonic frequency.

4. Method according to one of the preceding claims, **characterized in that** a false result of the first evaluation criterion is held for a predetermined number of time steps.

5. Method according to one of the preceding claims, **characterized in that** the first analysis criterion compares the high-pass filtered absolute of the DC value with a first threshold value, wherein the power is assumed as constant as long as the high-pass filtered absolute of the DC value is lower than the first threshold value.

6. Method according to one of the preceding claims, **characterized in that** the second analysis criterion compares an, in particular high-pass filtered, deviation value derived from the strength of the second harmonic to a second threshold value, wherein the deviation value is determined by

   - determining a relative strength of the second harmonic by dividing the absolute of the strength, in particular the amplitude, of the second harmonic by the absolute of the DC value of the power,
   - determining an expected value for the relative strength, and
   - determining the deviation value as the absolute of the difference of the relative strength and the expected value, wherein the second analysis criterion indicates a transient if the deviation value exceeds the second threshold value.

7. Method according to claim 5 or 6, **characterized in that** the deviation value and/or the DC value are pre-filtered before high-pass filtering.

8. Method according to one of the preceding claims, **characterized in that** the given number of time steps is at least two.

9. Method according to one of the preceding claims, **characterized in that**, if the interturn short-circuit fault signal indicates a detected interturn short-circuit fault, the generator (13), in particular at least the respective stator winding set (15, 23), is shut down and/or a warning is output.

10. Method according to one of the preceding claims, **characterized in that** the strength of the second harmonic is further evaluated regarding at least one further fault condition, in particular by diagnosing two different stator winding sets (15, 23) based on a second harmonic power difference between the respective strengths of the second harmonics.

11. Wind turbine (1), comprising a generator (13) having at least one stator (119) comprising at least one stator winding set (15, 23), measurement means for measuring a measurement signal of a power of the at least one stator winding set (15, 23) and a monitoring device (2), the monitoring device (2) being configured to perform the steps of a method according to one of the preceding claims.

12. Computer program, which performs the steps of a method according to one of the claims 1 to 10 if the computer program is executed on a monitoring device (2) of a wind turbine (1) .

13. Electronically readable storage medium, whereon a computer program according to claim 12 is stored.

FIG 1

FIG 2

FIG 3

FIG 4

FIG 5

Europäisches
Patentamt

European
Patent Office

Office européen
des brevets

# EUROPEAN SEARCH REPORT

Application Number

EP 22 21 6009

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2019/037908 A1 (SIEMENS GAMESA RENEWABLE ENERGY AS [DK]) 28 February 2019 (2019-02-28) * page 15, line 14 – page 23, line 19 * | 1-13 | INV. G01R31/34 G01R31/52 |
| A | US 2019/137568 A1 (FREIRE NUNO MIGUEL AMARAL [DK]) 9 May 2019 (2019-05-09) * paragraph [0059] – paragraph [0080] * | 1-13 | |
| A | SHIFENG ZHANG ET AL: "Two harmonic analysis of short circuit current in wind farm", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2017, no. 13, 1 January 2017 (2017-01-01), pages 996-1001, XP006065990, DOI: 10.1049/JOE.2017.0479 * the whole document * | 1-13 | |
| A | GRITLI YASSER ET AL: "A Diagnostic Space Vector-Based Index for Rotor Electrical Fault Detection in Wound-Rotor Induction Machines Under Speed Transient", IEEE TRANSACTIONS ON INDUSTRIAL ELECTRONICS, IEEE SERVICE CENTER, PISCATAWAY, NJ, USA, vol. 64, no. 5, 1 May 2017 (2017-05-01), pages 3892-3902, XP011645512, ISSN: 0278-0046, DOI: 10.1109/TIE.2017.2652389 [retrieved on 2017-04-10] * the whole document * | 1-13 | TECHNICAL FIELDS SEARCHED (IPC) G01R |

The present search report has been drawn up for all claims

| Place of search | Date of completion of the search | Examiner |
|---|---|---|
| Munich | 20 June 2023 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 6009

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2023

| Patent document cited in search report | | Publication date | Patent family member(s) | | Publication date |
|---|---|---|---|---|---|
| WO 2019037908 | A1 | 28-02-2019 | CN | 111226389 A | 02-06-2020 |
| | | | DK | 3652853 T3 | 30-08-2021 |
| | | | EP | 3652853 A1 | 20-05-2020 |
| | | | US | 2021028731 A1 | 28-01-2021 |
| | | | WO | 2019037908 A1 | 28-02-2019 |
| US 2019137568 | A1 | 09-05-2019 | CN | 109752654 A | 14-05-2019 |
| | | | DK | 3480610 T3 | 22-06-2020 |
| | | | EP | 3480610 A1 | 08-05-2019 |
| | | | US | 2019137568 A1 | 09-05-2019 |

EPO FORM P0459

For more details about this annex : see Official Journal of the European Patent Office, No. 12/82

**EP 4 390 414 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019037908 A1
- WO 2020128058 A1